# EUROPEAN PATENT APPLICATION

(11) **EP 2 525 634 A1**
(43) Date of publication of application: **21.11.2012**
(21) Application number: 10843123.0
(22) Date of filing: 22.11.2010
(51) Int. Cl.: H05K 3/00, H05K 3/20, H05K 3/38, H05K 3/46, B29C 33/12, B29C 45/14, H02M 3/28

(54) **SUBSTRATE AND METHOD OF MANUFACTURING SUBSTRATE**

(30) Priority: 13.01.2010 JP 2010004799
(71) Applicant: Furukawa Electric Co., Ltd., Chiyoda-ku Tokyo 100-8322 (JP); Furukawa Automotive Systems Inc., Inukami-gun, Shiga 522-0242 (JP)
(72) Inventor: HARA, Toshitaka, Tokyo 100-8322 (JP); TORATANI, Tomoaki, Tokyo 100-8322 (JP); ABE, Kyutaro, Tokyo 100-8322 (JP); MAENO, Koichi, Tokyo 100-8322 (JP); SHIBAMURA, Motomu, Tokyo 100-8322 (JP)
(74) Representative: Strehl Schübel-Hopf & Partner
(86) International application number: PCT/JP2010/070773
(87) International publication number: WO 2011/086768

(57) **Abstract**

A substrate usable for such as DC-DC converters, which has no defects such as openings therein but is more compact and easy to be manufactured and a method of manufacturing the same is provided. First, circuit materials are cut off by pressing and bended to be formed in desired shapes. Next, the circuit materials are joined or placed in predetermined positions to form a circuit conductor 15. Junction is performed by welding. Next, the circuit conductor 15 is installed on the mold 19. The mold 19 is for injection molding of resin 9 and has a predetermined cavity therein. The circuit conductor 15 is fixed to the mold 19, for example by a pin of a prescribed position. In such a condition, resin is injected into a mold. The substrate 1 is formed by the injection of resin to a surface and between layers of the circuit conductor.

## Description

### TECHNICAL FIELD

The present invention relates to a substrate for such as DC-DC convertors used for automobiles etc. and a method for manufacturing the same.

### BACKGROUND ART

A DC-DC converter used for an automobile comprises a plurality of components, such as a transformer for voltage conversion and a choke coil for smoothing. These components are separately manufactured and then connected with each other since high voltage and high current is loaded thereon (Patent document 1).

### PRIOR ART DOCUMENT(S)

### PATENT DOCUMENT(S)

[Patent document 1] Japanese Patent Laid Open No. 2005-143215

### SUMMARY OF INVENTION

### TECHNICAL PROBLEM TO BE SOLVED

In such a configuration, however, devices tend to become larger, therefore, more compact DC-DC converters have been demanded. Alternatively, a method to place the above-mentioned each component on the same substrate has been known. Usually, such a substrate that has electric circuits thereon comprises a layer structure with a plurality of circuits and insulators. However, circuits on an ordinary substrate are formed by plating, etching etc., and thus they cannot resist high current that flows into a DC-DC converter. Hence, in order to resist such high current, it is desirable for conductor layer thickness, for example, to be 0.4 mm or more. Conductor layer thickness tends to be increased in the conventional method, however, which makes difficult to form a conductor layer.

According to a conventional method, a conductor layer and glass epoxy is laminated for forming a substrate. In this conventional method, however, resin does not fully spread among each different conductor separated within the same layer. This may cause defects, such as openings, therein. Formation of openings may become a problem such as reducing insulation performance of the substrate. For the reasons outlined above, DC-DC converters which are more reliable, more compact, and easy to be manufactured at low cost have been demanded.

The present invention has been made in view of such problems. The object of the present invention is to provide a substrate usable for such as DC-DC converters, which has no defects such as openings, therein but is more compact and easy to be manufactured, and also to provide a method of manufacturing the same.

### SOLUTION TO PROBLEM

In order to achieve the above-mentioned object, the present invention provides a method for manufacturing a substrate comprising the steps of forming a plurality of circuit materials, joining predetermined portions of the circuit materials to form a circuit conductor with a plurality of layers, and injecting molding resin to a surface of the circuit conductor and/or between the layers of the circuit conductor.

In the present invention, an insulating member having a lower melting point than that of the resin may be put at least in a part between the layers of the circuit conductor before injection of the resin.

In the present invention, a surface of the circuit conductor or a surface of the circuit material may be processed by surface roughening treatment in advance before injection of the resin.

In the present invention, a resin attaching part with a taper portion having a diameter reduced to a side covered by the resin may be provided on the surface of the circuit conductor or the surface of the circuit material so that the resin is fixed to the circuit conductor when the resin is injected inside of the resin attaching part.

In the present invention, the circuit materials may be jointed such that edges of the circuit materials to be jointed with each other are bended approximately perpendicular to aspects of each of the circuit materials respectively to form bended portions and the bended portions are overlapped with other and then welded.

In the present invention, a slot that serves as a flow path of the resin at a time of injection molding of the resin may be formed beforehand on the circuit conductor.

In the present invention, a convex part having a peripheral portion being protruded in a ribbed shape may be formed in a part of a mold for injection molding of the resin so that a region for installing an electronic component, with which the resin does not cover, is formed on a surface of the substrate when the resin is injected in a state where the convex part is pressed against the surface of the circuit conductor.

According to a first aspect of the present invention, a multiple layered substrate can be easily formed even with a relatively thick circuit conductor such as a thick copper, and also, resin can be certainly flown between the layers of the circuit conductor since a resin portion is formed by injection molding. In this way, the present invention can provide a method of manufacturing a substrate that is easy to be manufactured

Also, according to the first aspect of the present invention, the insulating member having the lower melting point than that of resin is put between the layers of the circuit conductors to be laminated. The insulating member is dissolved and certainly integrated with the circuit material at the time of injection molding of resin. With this configuration, the insulating member enables to certainly insulate between the circuit conductors even when the circuit conductors are laminated with closely-intervals, such as for a coil.

Also, according to the first aspect of the present invention, as concavo-convex is formed on the surface of the circuit conductor by surface roughening treatment beforehand, resin and the circuit conductor is integrated firmly by anchor effect, and thereby, it can be prevented that resin falls out from the circuit conductor.

Also, according to the first aspect of the present invention, as the resin attaching part with the taper portion having the diameter reduced to the side covered by resin is formed, resin flows into the inside of the resin attaching part, thereby, resin can be certainly integrated with the circuit conductor by anchor effect.

Also, according to the first aspect of the present invention, the edges of the jointed portion are bended in a direction of the aspects of the materials (perpendicular to the aspects of each of the circuit materials) and the bended portions are overlapped with each other and then welded. With this configuration, as it is possible to weld in an outer side of the circuit materials to be laminated and a state in which the bended portions are welded can be viewed from outside, a portion for welding is not necessarily to be arranged inside of the circuit conductor (between the layers or on a back side thereof).

Also, according to the first aspect of the present invention, as the slot which serves as the flow path of resin is formed on the surface of the circuit conductor (the circuit material), flow of resin increases and a defective flow of resin can be prevented.

Also, according to the first aspect of the present invention, for forming a portion where a conductor circuit portion of the circuit conductor is exposed to outside, the convex part having the peripheral portion protruded in a ribbed shape is formed in a part of the mold for injection molding of resin may be formed so that pressure of the convex part against the circuit conductor may increase. Thereby, although resin is injected in a state that the convex part is pressed against the conductor circuit, it can be prevented that resin flows into a gap between the upper aspect of the convex part and the circuit conductor.

A second aspect of the present invention relates to the substrate comprising the circuit conductor having a plurality of layers and resin that is formed by injection molding between the layers of the circuit conductors and to the surface of the circuit conductor, wherein the electronic component mounting part for installing an electronic component, which is not covered with resin, is formed on the surface of the circuit conductor, wherein the size of the electronic component mounting part is approximately the same as the electronic component to be installed thereon, and wherein the degassing part that is not covered by resin is formed in the peripheral portion of the region.

According to the second aspect of the present invention, a position for installing an electronic component can be certainly maintained as the electronic component mounting part is formed by injection molding. Further, a degassing part that is not covered with resin (a region, where is formed such that it is extended to outside from the electronic component mounting part, as well as where is continuous to the electronic component mounting part, without covered with resin) is formed around the electronic component mounting part. With this configuration, gas generated by a solder at the time of soldering the electronic components escapes from the degassing part and reliability of soldering junction can be increased.

### ADVANTAGEOUS EFFECTS OF INVENTION

According to the present invention, it is able to provide a substrate usable for such as DC-DC converters, which has no defects, such as openings, therein and is compact and easy to be manufactured, and also to provide a method of manufacturing the same.

### BRIEF DESCRIPTION OF THE DRAWINGS

[Fig. 1] Fig. 1 illustrates a substrate 1, particularly Fig. 1 (a) is a front side perspective view and Fig. 1 (b) is a back side perspective view.
[Fig. 2] Fig. 2 illustrates a substrate 1, particularly Fig. 2 (a) is a top view and Fig. 2 (b) is a back view.
[Fig. 3] Fig. 3 is a sectional view of a substrate 1, particularly Fig. 3 (a) is an A-A line sectional view of Fig. 2 (a) and Fig. 3 (b) illustrates an alternate embodiment.
[Fig. 4] Fig. 4 is an exploded view of a circuit material.
[Fig. 5] Fig. 5 illustrates a circuit conductor 15 which is constructed with circuit materials.
[Fig. 6] Fig. 6 illustrates embodiments for welding portions of the circuit materials.
[Fig. 7] Fig. 7 illustrates a state in which a circuit conductor is installed in a mold for injection of molding.
[Fig. 8] Fig. 8 (a) illustrates a ribbed shape of a periphery of a convex part 20a arranged with a mold, Fig. 8 (b) illustrates a convex part 20b, and Fig. 8 (c) is an enlarged view of a B section of Fig. 8 (b).
[Fig. 9] Fig. 9 illustrates shapes of resin attaching parts.
[Fig. 10] Fig. 10 illustrates a shape of an electronic component mounting part 7 having degassing parts 25.

### DETAILED DESCRIPTION OF EMBODIMENTS

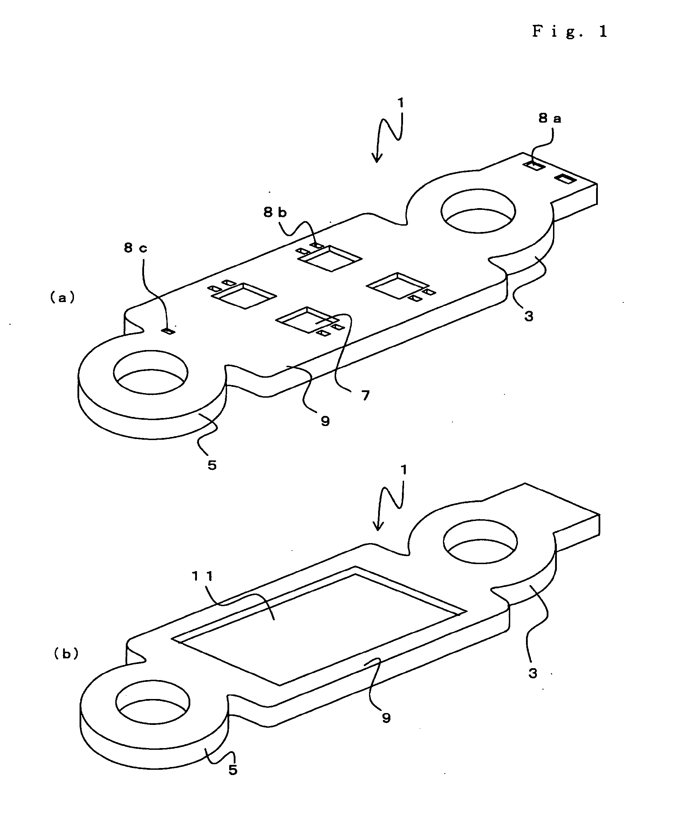

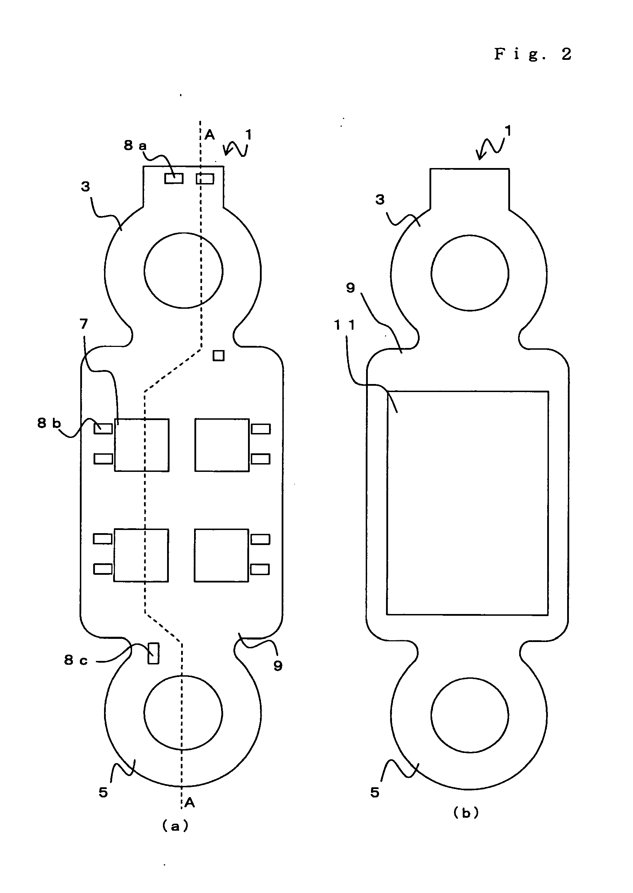

Hereinafter, embodiments of the present invention will be described with reference to the accompanying drawings. Fig. 1 and Fig. 2 are perspective views illustrating a substrate 1. Fig. 1 (a) is a front side perspective view, and Fig. 1 (b) is a back side perspective view. Fig. 2 (a) is a top view, and Fig. 2 (b) is a back view. The substrate 1 has a transformer 3 and a choke coil 5 and is used for such as DC-DC convertors for automobiles. At the substrate 1, circuit conductors that are arranged inside of an electronic component mounting part 7, terminal areas 8a, 8b, and 8c, a radiator 11 etc., are exposed to outside, and the other portions are covered with resin 9. Regarding the circuit conductor, it will be described later below.

The transformer 3 is a coil for voltage conversion and lowers electrical pressure of current inputted from the terminal area 8a. The choke coil 5 smoothes the current having the lowered electrical pressure and then this current is outputted to outside by the terminal area 8c. The electronic component mounting part 7 is arranged for installing an electronic material etc. and is electrically connected with the substrate 1 via such as the terminal area 8b.

The radiator 11 is formed on a back side of the electronic component mounting part 7. The radiator 11 emits, to outside, the heat generated by energizing electronic components to be installed on the electronic mounting part 7 as well as by energizing the circuit conductor of the substrate. Needless to say, the formations and shapes of the substrate according to the present invention are not restricted to the ones as illustrated in the drawings. Other components etc. may be arranged thereon suitably, or other formations and shapes may be employed suitably.

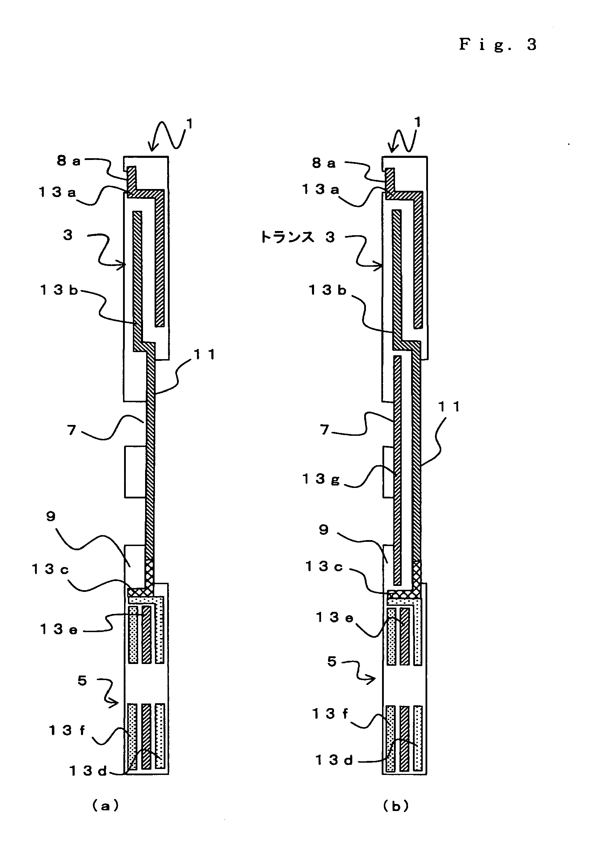

Fig. 3 (a) is an A-A line sectional view of Fig. 2 (a). As illustrated in Fig. 3 (a), the substrate 1 has a plurality of circuit materials 13a-13f therein and is covered with resin 9 except for some portions exposed to outside. The one which is arranged in a state where the circuit materials 13a-13f are jointed with each other or which is arranged to electronically function is called a circuit conductor as a whole.

For example, the circuit material 13a is a coil and is arranged to have a predetermined interval from the tabular circuit material 13b. In a part of a surface of the circuit material 13b, an exposed portion (the electronic component mounting part 7) which is not covered with resin 9 is formed, and in a back side of the circuit material 13b, a similar kind of exposed portion (the radiator 11) is formed as well. The circuit material 13b is electrically joined to the circuit material 13c, and the circuit material 13c is further joined to the choke coil 5 that is formed with the mutually joined circuit materials 13d, 13e, and 13f.

The circuit materials 13a-13f are approximately 0.1 mm - 1 mm in thickness, and more desirably, are to be 0.4 mm - 0.7 mm in thickness. The thickness is set in this way because when a circuit material is too thin, it cannot resist high current, but when a circuit material is too thick, a compact substrate cannot be formed as the cost and weight increases. Since a circuit material is thicker than a circuit conductor of the conventional substrate as mentioned above, it cannot be formed by plating, etching, etc. but is formed by press processing. A circuit material is desirable to be a conductor as well as to be a metal having a small electrical resistance and a small heat resistance, for example, a copper alloy can be used.

Resin 9 is formed on the surface of the circuit conductor and between the layers of the circuit conductor such that the circuit conductor may be covered with resin 9 or in order to maintain intervals of each circuit material. Resin 9 is provided by injection molding. As resin 9, the ones which are insulating and capable of being injected for molding are good for use, for example, a liquid crystal polymer, poly phenylene sulfide, polybutylene terephthalate, poly ether sulphone, polyether ether ketone, poly phthalamide, etc. can be used.

The circuit conductor may be formed with a plurality of layers of circuit materials. For example, as illustrated in Fig. 3 (b), the circuit may be arranged such that the circuit material 13g is provided in a position with which the circuit material 13b overlaps and then such that resin 9 is injected between the layers of the circuit materials 13b and 13g in order to prevent the direct conduction that might be occurred therebetween. In such an arrangement of a plurality of layers, the substrate 1 can be smaller in size.

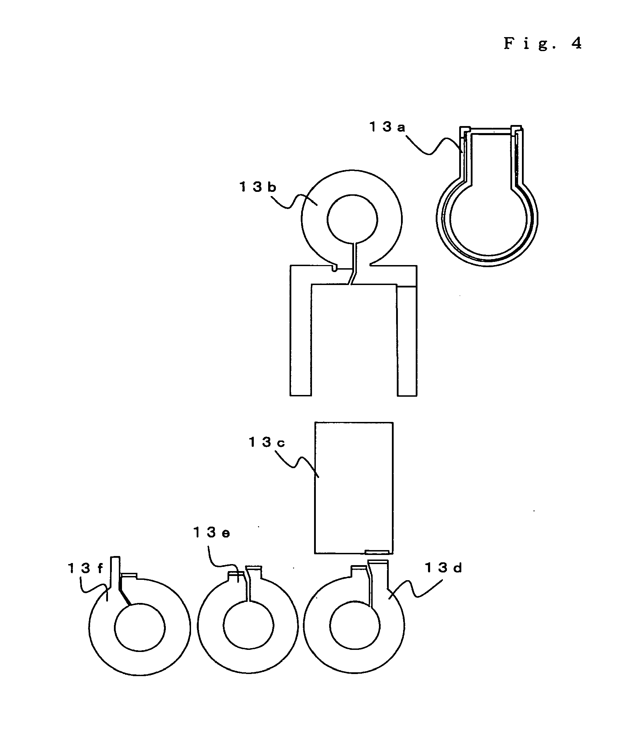

Hereinafter the details of the method of manufacturing the substrate 1 will be described. First, as illustrated in Fig. 4, the circuit materials 13a-13f are cut off by pressing and formed in desired shapes by bending. In this process, concavo-convex shapes may be provided on a surface of a press die to form fine concavo-convex shapes on each of the surfaces of the circuit materials. With increasing the roughness of the surfaces, adhesion of the circuit material with resin may be improved by anchor effect. In order to roughen the surfaces of the circuit materials, the concavo-convex shape may be formed by blast processing, copper plating roughening, nickel plate roughening, etc. other than press molding.

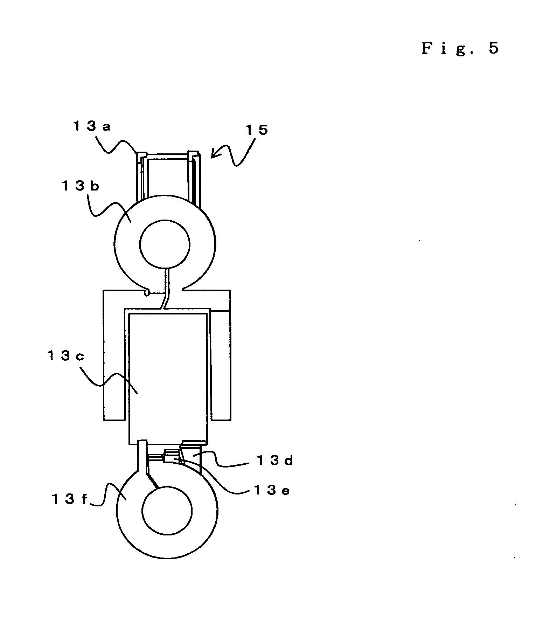

Next, as illustrated in Fig. 5, the circuit materials are joined with each other or placed in predetermined positions to form the circuit conductor 15. They are joined, for example, by welding. In this process, when a plurality of circuit materials are overlapped with each other and then placed, insides of portions where the circuit materials are overlapped with each other cannot be viewed. This makes it difficult to weld the materials, and moreover, this may cause such as an insulation failure if foreign substances, such as dregs, which are generated at the time of welding remain therein. For the reasons outlined above, it is desirable to join them on a front surface of the circuit materials.

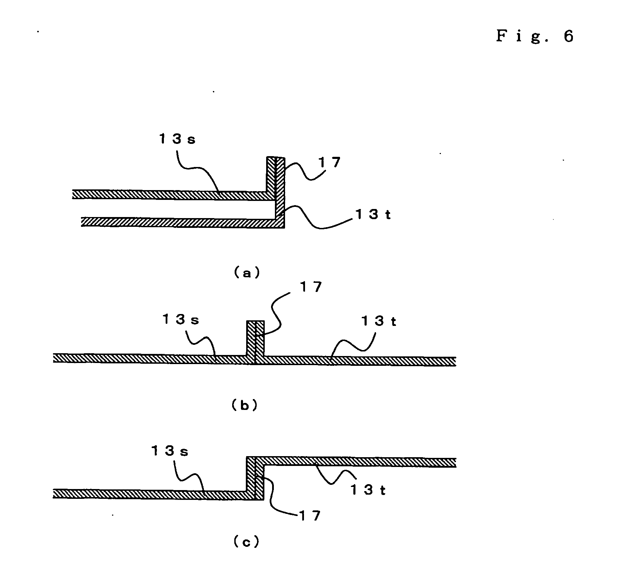

Fig. 6 illustrates each embodiment in which the circuit materials are joined with each other. For example, as illustrated in Fig. 6 (a), when the circuit materials 13s and 13t are joined such that they are overlapped with each other, edges of each of the circuit materials 13s and 13t are bended in the same direction in the joined formation (approximately perpendicular to an aspect of the circuit material) to form bended portions, and the bended portions of each of the materials are overlapped and then joined with each other. This makes possible that the jointed portion can be viewed from outside and may not allow foreign substances which are generated at the time of welding to remain between the layers of the circuit materials 13s and 13t.

Also as illustrated in Fig. 6 (b), when the circuit materials 13s and 13t are joined on the same plane, similarly, edges of each of the circuit materials 13s and 13t are bended in the same direction in the jointed formation to form bended portions, and after that, the bended portions of each of the circuit materials are overlapped and then jointed with each other. With this configuration, the jointed portion can be viewed from outside, and it also may not allow foreign substances which are generated at the time of welding to remain on a back side of the circuit materials 13s and 13t.

As illustrated in Fig. 6 (c), when the circuit materials 13s and 13t are joined in uneven levels, similarly, edges of each of the circuit materials 13s and 13t are bended in each direction of junctions to form bended portions and after that, the bended portions of each of the circuit materials are overlapped and then jointed with each other. With this configuration, the jointed portion can be viewed from outside. In this case, approximately the same jointed formation as the one illustrated in Fig. 6 (b) may be obtained by extending the jointed portion of the circuit material 13s and then bending the circuit material 13t upward in Fig. 6 (c).

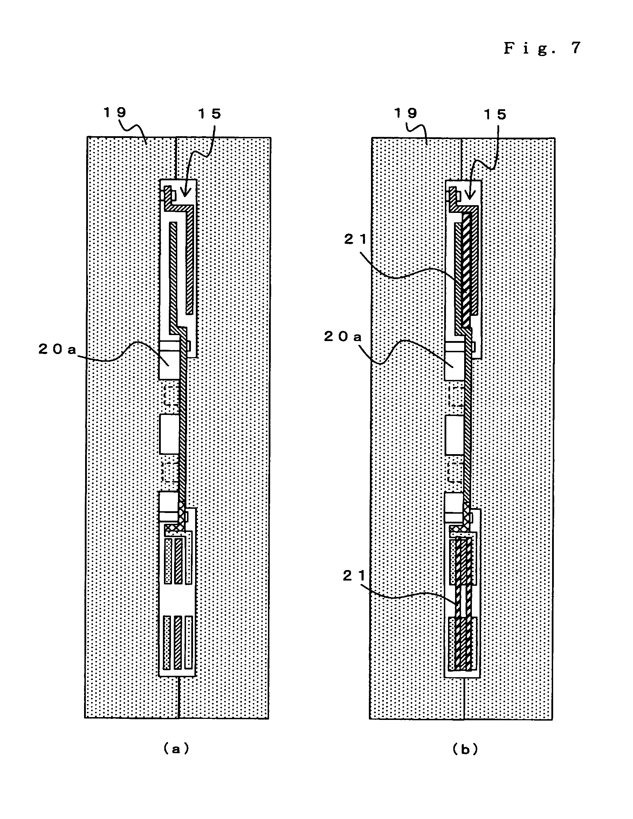

Next, as illustrated in Fig. 7 (a), the circuit conductor 15 is installed on the mold 19. The mold 19 is for injection of resin 9 and has a predetermined cavity formed therein. The circuit conductor 15 is fixed to the mold 19, for example, such as by a pin of a predetermined position. In this condition, the substrate 1 is formed by injection of resin to the mold 19. Further, a slot is formed on the circuit conductor 15 (each of the circuit materials) beforehand in a direction of the flow of resin 9 so that the slot can be a flow path of resin 9. With this configuration, resin 9 can be flowed into the mold completely and also defective flow of resin 9 can be prevented.

As illustrated in Fig. 7 (b), in a portion where the circuit materials are overlapped with each other (especially, in a portion where the circuit materials for a coil or a transformer should be arranged to have an interval in order to maintain a certain distance therebetween), when the substrate is formed in a state where the circuit materials are arranged to have an interval but without any contacts with each other, an insulation material 21 may be put into a gap between the circuit materials beforehand. As for the insulation material 21, the material having a lower melting point than that of resin 9 is used. Hereby, at the time of injection molding resin 9, the insulation material 21 is dissolved and firmly integrated with the circuit materials. The insulation material 21 also can prevent the circuit materials from being conducted by deformation at the time of injection of resin 9, therefore, the distances between the circuit materials can be maintained certainly.

Here, a convex part 20a is partially formed in the mold 19 and is pressed against a part of the circuit conductor 15. A portion, where the convex part 20a is pressed against the circuit conductor 15, is not covered with resin 9, but becomes an exposed portion (for example, the electronic component mounting part 7 etc.) of the circuit conductor.

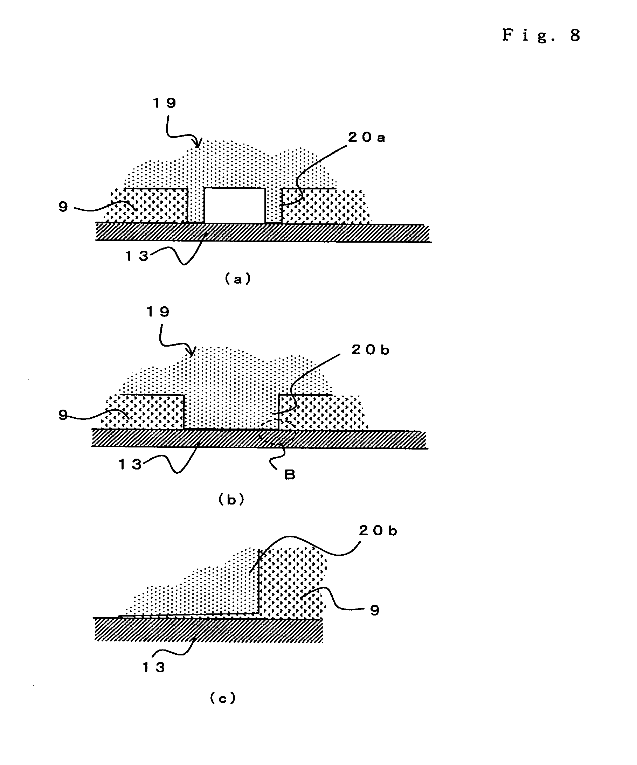

Fig. 8 (a) illustrates a sectional view of the convex part 20a. As illustrated in Fig. 8 (a), a peripheral portion of the convex part 20a is protruded in a ribbed shape, and a space (dent) is formed in a portion, surrounded with a rib, of the convex part 20a. Hence, only the rib portion (the peripheral portion) of the convex part 20a contacts the circuit conductor (the circuit material) and is pressed against the surface of the circuit material in a state where the circuit conductor 15 is installed on the mold 19. Thereby, this enables to increase pressure which is generated when the convex part 20a is pressed against the surface of the circuit material.

For example, as illustrated in Fig. 8 (b) if a conventional convex part 20b, of which an inner portion has no space at all, is used, a whole surface of the convex part 20b will contact the surface of the circuit material 13. With this configuration, pressure which is generated when the convex part 20b is pressed against the circuit material 13 becomes small.

Fig. 8 (c) is an enlarged view of the B section in Fig. 8 (b). As illustrated in Fig. 8 (c), when resin 9 is injected, an edge of the convex part 20b may slightly float since the pressure of the convex part 20b is small. It may lead to the possibility that resin 9 gets into a gap between the convex part 20b and the circuit material 13. In this case, the circuit conductor may not be certainly exposed to outside and a defective continuity etc. may be caused. For the reasons outlined above, it is desirable to use the convex part 20a having a periphery being protruded in a ribbed shape.

As described above, according to the present embodiments, a thick copper board can be formed since the circuit materials are formed by pressing, and furthermore, since resin 9 is formed by injection molding, the substrate 1 which has high manufacturability as well as is strong enough to bear high current can be obtained.

Also, according to the substrate 1 of the present embodiments, high design flexibility and high manufacturability can be achieved as the circuit materials are formed separately and then connected with one another. Furthermore, the circuit materials may be arranged such that they are overlapped with each other, which makes it possible to form a coil etc. by pressing, and also makes it possible to manufacture the substrate 1 in smaller size. In this process, the distance of the circuit materials can be maintained certainly and also defective insulation etc. can be prevented when the insulation material 21 having a lower melting point than that of resin 9 is put between the circuit materials.

Moreover, as for the jointed portion of the circuit materials, the welding portion can be viewed from outside when the edges of the circuit materials are bended and then overlapped for welding. Thereby, foreign substances etc. generated at the time of welding may not be remained within the circuit conductor.

Furthermore, as the convex part 20a has a periphery being protruded in a ribbed shape in order to form the exposed portions on the circuit conductor at the substrate, the pressure of the convex part 20a against the surface of the circuit material can be increased, and thus, it can be prevented that resin 9 flows into the gap between the convex part 20a and the surface of the circuit material. Additionally, resin 9 and the circuit material 13 can be integrated firmly by increasing the roughness of the surface of the circuit material.

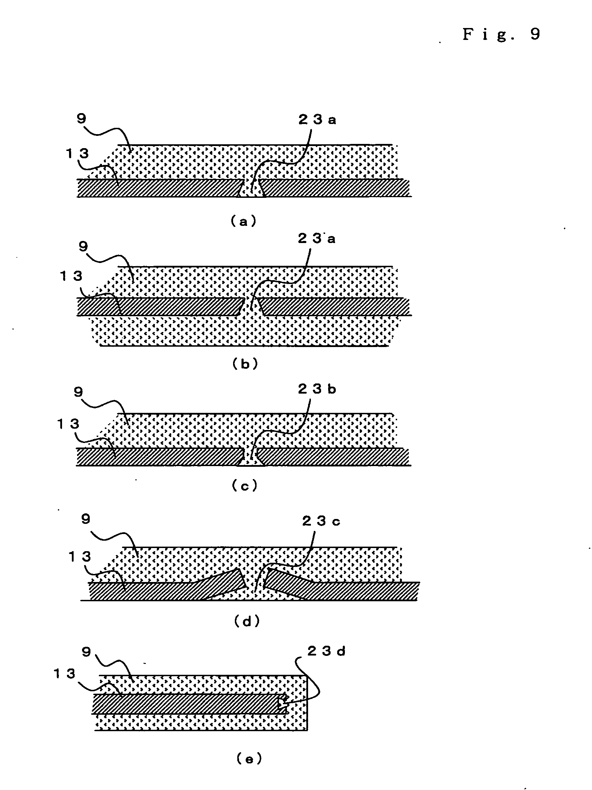

In order to integrate resin 9 and the circuit material more firmly, a resin attaching part as illustrated in Fig. 9 may be formed. For example, as illustrated in Fig. 9 (a), a hole (a resin attaching part 23a) with a taper portion having a diameter reduced to a side covered with resin 9 is provided in a part of the circuit material 13. This allows resin 9 to enter inside of the resin attaching part 23a at the time of injection molding. With this configuration, resin 9 is certainly maintained by the resin attaching part 23a and does not fall away from the circuit material, or a gap is not caused therein.

As illustrated in Fig. 9 (b), when resin 9 is formed in both sides of the circuit material, a hole with a taper portion having a diameter reduced to one of the sides with which resin 9 covers may be formed.

A taper portion should not necessarily be formed within an entire portion of the hole. As illustrated in Fig. 9 (c), a resin attaching part 23b with a taper portion having a diameter reduced to a side covered with resin 9 may be formed in a part of a depth direction.

As illustrated in Fig. 9 (d), even when a taper portion is not arranged at a wall portion within a hole, a part of the circuit material 13 may be bended to form a protrusion. A resin attaching part 23c is formed such that a hole is provided in a part of the circuit material 13 and then a peripheral portion of the hole is bended to be protruded to a side, which is to be covered with resin 9, of the circuit material 13. In the resin attaching part 23c, the same effect may also be obtained since a taper portion having a diameter reduced to a side covered with resin 9 is formed at back side of the circuit material 13.

As illustrated in Fig. 9 (e), a resin attaching part 23d comprising a concave portion instead of a hole may be arranged. The resin attaching part 23d has a taper portion of which a diameter is reduced to a side covered with resin 9. The same effect can be obtained, for example, when the resin attaching part 23d is arranged in a shape of a slot and provided at such as a side of the circuit material 13.

It is desirable for the electronic component mounting part 7 to be approximately the same shape (to be slightly larger than the size of an electronic component to be installed thereon) and to be capable of installing an electronic component on its installing position certainly. In this process, a degassing part 25 may be formed in a part of a peripheral portion of the electronic component mounting part 7 (for example, in its four corners).

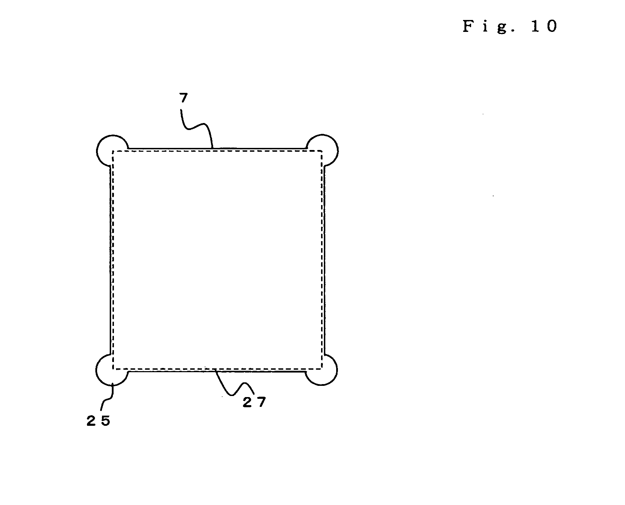

Fig. 10 illustrates the electronic component mounting part 7 in which the degassing part 25 was formed. As mentioned above, an electronic component (dotted line portion) is slightly smaller than the electronic component mounting part 7 (the region which is not covered with resin), and the electronic component 27 is certainly installed in the electronic component mounting part 7. In this process, for example, if the electronic component 27 is soldered to the electronic component mounting part 7, a defect may be caused in a soldering portion. This is because gas etc. that is generated in a lower aspect of the electronic component 27 by flux for solder cannot escape to outside when the gap between side portions of the electronic component 27 and the electronic component mounting part 7 is small. This will become a problem particularly when resin formed by injection molding is thicker than the one of the conventional substrate 1.

On the other hand, the degassing part 25 is not covered with resin 9 in the same way as the electronic component mounting part 7 and forms a continuous field which is not covered with resin. With this configuration of the degassing part 25, when soldering the electronic component 27 to the electronic component mounting part 7, gas generated in a lower aspect of the electronic component 27 can escape to outside. This will prevent a defect in solder caused by gas.

Although the embodiments of the present invention have been described as the above referring to the drawings attached hereto, the technical scope of the present invention is not limited to the embodiments mentioned above. Apparently, a person skilled in the art is able to achieve other variations or modifications within a category of the technical ideas described in claims according to the present invention, and these variations and modifications will be considered to naturally belong to a technical scope of the present invention.

### REFERENCE SIGNS LIST

1 Substrate
3 Transformer
5 Choke coil
7 Electronic component mounting part
8a, 8b, 8c Terminal area
9 Resin
11 Radiator
13, 13a, 13b, 13c, 13d, 13e, 13f, 13g Circuit material
15 Circuit conductor
17 Welding part
19 Mold
20a, 20b Convex part
21 Insulation material
23a, 23b, 23c, 23d ...... Resin attaching part
25 Degassing part
27 Electronic components

## Claims

1. A method of manufacturing a substrate comprising the steps of:
forming a plurality of circuit materials;
joining predetermined portions of the circuit materials to form a circuit conductor with a plurality of layers; and
injecting molding resin to a surface of the circuit conductor and/or between the layers of the circuit conductor.

2. A method of manufacturing a substrate according to claim 1, wherein an insulating member having a lower melting point than that of the resin is put at least between a part of the layers of the circuit conductor before injection of the resin.

3. A method of manufacturing a substrate according to claim 1, wherein a surface of the circuit conductor or a surface of the circuit material is processed by surface roughening treatment in advance before injection of the resin.

4. A method of manufacturing a substrate according to claim 1, wherein a resin attaching part with a taper portion having a diameter reduced to a side covered with the resin is provided on the surface of the circuit conductor or the surface of the circuit material so that the resin is fixed to the circuit conductor when the resin is injected inside of the resin attaching part.

5. A method of manufacturing a substrate according to claim 1, wherein the circuit materials are jointed such that edges of the circuit materials to be jointed with each other are bended approximately perpendicular to aspects of each of the circuit materials respectively to form bended portions and the bended portions are overlapped with each other and then welded.

6. A method of manufacturing a substrate according to claim 1, wherein a slot that serves as a flow path of the resin at a time of injection molding of the resin is formed beforehand in the circuit conductor.

7. A method of manufacturing a substrate according to claim 1, wherein a convex part having a peripheral portion being protruded in a ribbed shape is formed in a part of a mold for injection molding of the resin so that a region for installing an electronic component, with which the resin does not cover, is formed on a surface of the substrate when the resin is injected in a state where the convex part is pressed against the surface of the circuit conductor.

8. A substrate comprising:
a circuit conductor having a plurality of layers; and
resin that is formed by injection molding between layers of the circuit conductors and to a surface of the circuit conductor,
wherein an electronic component mounting part for installing an electronic component, with which the resin does not cover, is arranged on the surface of the circuit conductor;
wherein size of the electronic component mounting part is approximately the same as that of the electronic component to be jointed with; and
wherein a degassing part that is not covered with the resin is formed in a peripheral portion of the electronic mounting part.
